# DEMANDE DE BREVET EUROPEEN

(11) **EP 0 881 672 A1**
(43) Date de publication de la demande: **02.12.1998**
(21) Numéro de dépôt: 98410055.2
(22) Date de dépôt: 22.05.1998
(51) Int. Cl.: H01L 21/761, H01L 27/08

(54) **Mur d'isolement entre composants de puissance**

(30) Priorité: 28.05.1997 FR 9706822
(71) Demandeur: SGS-THOMSON MICROELECTRONICS S.A., 94250 Gentilly (FR)
(72) Inventeur: Duclos, Franck, 37000 Tours (FR); Rami, Fabien, 37230 Fondettes (FR)
(74) Mandataire: de Beaumont, Michel

(57) **Abrégé**

L'invention concerne un mur d'isolement destiné à séparer des composants élémentaires formés dans des caissons différents, un composant situé dans l'un au moins des caissons étant susceptible de fonctionner avec une densité de courant importante. Le mur d'isolement présente dans sa partie médiane une concentration de porteurs supérieure à 10¹⁶ atomes/cm³. De préférence, la largeur des ouvertures à partir desquelles sont formées les diffusions de dopants dans les surfaces supérieure et inférieure du substrat est supérieure à 1,3 fois la demi-épaisseur du substrat.

## Description

La présente invention concerne les composants semiconducteurs de puissance, c'est-à-dire des composants susceptibles de commuter des courants importants et/ou de supporter des tensions élevées.

Classiquement, les composants de puissance et/ou haute tension étaient réalisés sous forme de composants discrets. Eventuellement, pour assurer l'isolement latéral de ces composants et améliorer leur tenue en tension, la périphérie des composants était constituée d'un mur d'isolement formé par diffusion profonde d'atomes dopants à partir des faces supérieure et inférieure d'une plaquette de silicium, la découpe étant formée au milieu de ce mur d'isolement.

Avec l'évolution des techniques, on en est venu à fabriquer plusieurs composants de puissance et notamment plusieurs composants verticaux dans une même puce. Des exemples de telles structures sont notamment décrits dans la demande de brevet européen EP-A-0721218 de la demanderesse (inventeur R. Pezzani). Le contenu de cette demande de brevet sera considéré comme faisant partie intégrante de la présente demande. Dans cette demande de brevet, comme dans toutes les descriptions de composants formés dans des caissons séparés les uns des autres par des murs d'isolement, on considère que chacun des composants formé dans un caisson entouré d'un mur d'isolement est convenablement isolé des composants adjacents qui n'influent pas les uns sur les autres.

La demanderesse a constaté dans certaines structures comprenant plusieurs composants formés dans des caissons distincts séparées par des murs d'isolement que le passage d'un courant important dans un composant pouvait provoquer des effets parasites sur un composant adjacent.

La présente invention se base sur une analyse de ce problème et de ses causes et propose des moyens pour y remédier.

Plus particulièrement, la présente invention propose une structure de mur d'isolement qui présente un niveau de dopage supérieur à 10¹⁶ atomes/cm³ au niveau de sa partie médiane, au point de rencontre de diffusions profondes formées à partir des faces supérieure et inférieure.

En outre, la présente invention propose que, de préférence, la partie médiane du mur d'isolement ait une étendue latérale supérieure à la demi épaisseur de la plaquette dans laquelle sont formées les diffusions profondes.

Plus particulièrement, la présente invention prévoit une structure de mur d'isolement destiné à séparer des composants élémentaires formés dans des caissons différents, un composant situé dans l'un au moins des caissons étant susceptible de fonctionner avec une densité de courant importante, dans laquelle le mur d'isolement présente dans sa partie médiane une concentration de porteurs supérieure à 10¹⁶ atomes/cm³.

Selon un mode de réalisation de la présente invention, la largeur des ouvertures à partir desquelles sont formées les diffusions de dopants dans les surfaces supérieure et inférieure du substrat est supérieure à 1,3 fois la demi-épaisseur du substrat.

La présente invention s'applique à constituer une séparation entre deux caissons contenant des triacs verticaux.

La présente invention s'applique à séparer deux caissons dont l'un au moins comprend une diode, un thyristor ou un triac vertical.

Selon un mode de réalisation de la présente invention, les divers composants sont de type vertical et la puce semiconductrice comprend une métallisation unique en face arrière.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 représentent divers assemblages de composants et sont destinées à illustrer le problème que la présente invention vise à résoudre ;
les figures 4A et 4B illustrent des étapes classiques de fabrication d'un mur d'isolement ;
la figure 5 représente des courbes de concentration de porteurs en fonction de la distance transverse et est destinée à exposer l'état de la technique ;
la figure 6 représente l'allure d'un mur d'isolement selon la présente invention ; et
les figures 7 et 8 sont des courbes de concentration de porteurs en fonction de la distance transverse et sont destinées à exposer l'apport de la présente invention.

Comme cela est classique dans le domaine de la représentation des composants semiconducteurs, les diverses vues en coupe sont fortement schématiques et ne sont pas tracées à l'échelle. L'homme de l'art saura choisir les profondeurs de jonction et les dimensions latérales des composants en fonction des performances de tenue en tension et de puissance qu'il recherche.

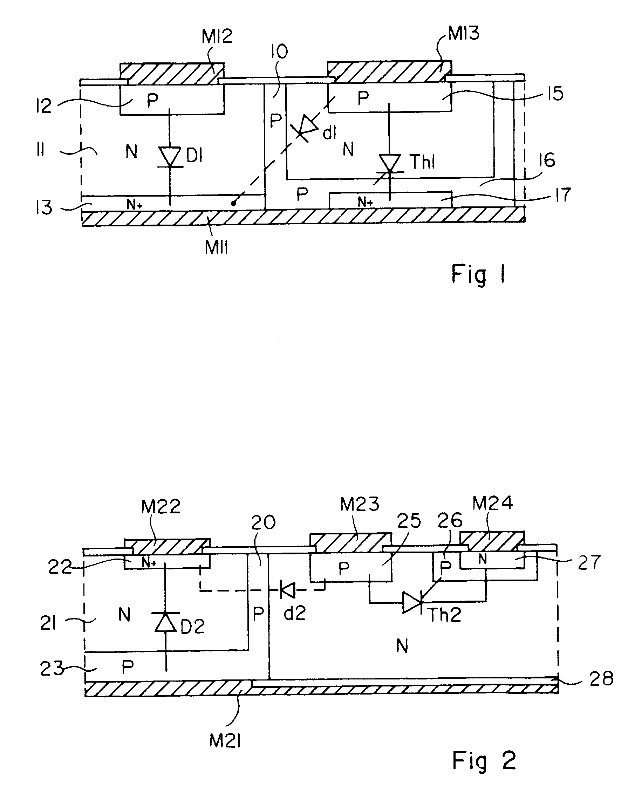

La figure 1 représente un exemple d'association d'une diode et d'un thyristor à cathode commune. Cette figure est extrêmement simplifiée et seules les parties utiles à l'exposé de l'invention ont été représentées. Notamment la structure de gâchette du thyristor n'est pas représentée.

La partie gauche de la figure 1 correspond à une diode verticale D1 et la partie droite à un thyristor vertical Th1 formé dans un caisson séparé de la partie gauche par un mur d'isolement 10 de type P. La structure est formée dans un substrat 11 de type N. La diode D1 comprend une région 12 de type P formée du côté de la face supérieure du substrat et une région 13 fortement dopée de type N du côté de la face inférieure du substrat. Le thyristor Th1 comprend une région 15 de type P formée du côté de la face supérieure du substrat, une région 16 de type P formée du côté de la face inférieure et une région 17 de type N formée dans la région 16 du côté de la face inférieure du substrat. La face inférieure de la structure est revêtue d'une métallisation de cathode M11. La région 12 est revêtue d'une métallisation M12 d'anode de la diode et la région 15 est revêtue d'une métallisation M13 d'anode du thyristor.

Le rôle classique du mur d'isolement 10 est d'éviter l'apparition de composants parasites. En effet, en l'absence de ce mur d'isolement, il existerait entre les métallisations M3 et M1 une diode PNN⁺ d1 constituée des régions 15, 11 et 13. Cette diode d1 fonctionnerait dès que la métallisation M3 serait polarisée positivement par rapport à la métallisation M1 et entraînerait la mise en conduction du thyristor Th1 en l'absence de courant de gâchette. La présence du mur d'isolement 10 entraîne que le trajet dans le substrat 11 est interrompu par deux diodes en série et en inverse dont l'une est forcément bloquante.

On notera que l'effet parasite de la diode d1 se produit quelle que soit la polarisation de la métallisation M2 et quel que soit le courant circulant dans la diode D1. On peut donc dire que le mur d'isolement a un effet statique d'isolement en tension.

La figure 2 représente un exemple schématique d'une structure associant une diode verticale D2 à un thyristor latéral Th2. Ces deux composants sont séparés par un mur d'isolement 20. La structure est formée dans un substrat 21 de type N. La diode D2 comprend du côté de la face supérieure une région 22 de type N et du côté de la face inférieure une région 23 de type P. Le thyristor Th2 comprend du côté de la face supérieure une région 25 de type P et une région 26 de type P dans laquelle est formée une région 27 de type N. Le caisson N dans lequel est formé le thyristor latéral est revêtu du côté de sa face inférieure d'une couche isolante 28. La face inférieure est revêtue d'une métallisation M21 d'anode de la diode. La région 22 est revêtue d'une métallisation M22 de cathode de la diode. La région 25 est revêtue d'une métallisation M23 d'anode du thyristor latéral. La région 27 est revêtue d'une métallisation M24 de cathode du thyristor.

Comme dans le cas de la figure 1, par souci de clarté, la structure a été simplifiée et notamment la gâchette du thyristor n'est pas représentée.

En l'absence du mur d'isolement 20, il existerait une diode PNN⁺ d2 entre les métallisations M23 et M22 et, si l'anode M23 du thyristor est polarisée positivement par rapport à la métallisation M22, la mise en conduction de la jonction entre la région 25 et le substrat 21 entraînera le déclenchement du thyristor Th2 en l'absence de courant de gâchette.

Ici aussi, le mur d'isolement sert à éviter l'existence d'une diode parasite. A nouveau, le mur d'isolement a un effet statique de protection en tension.

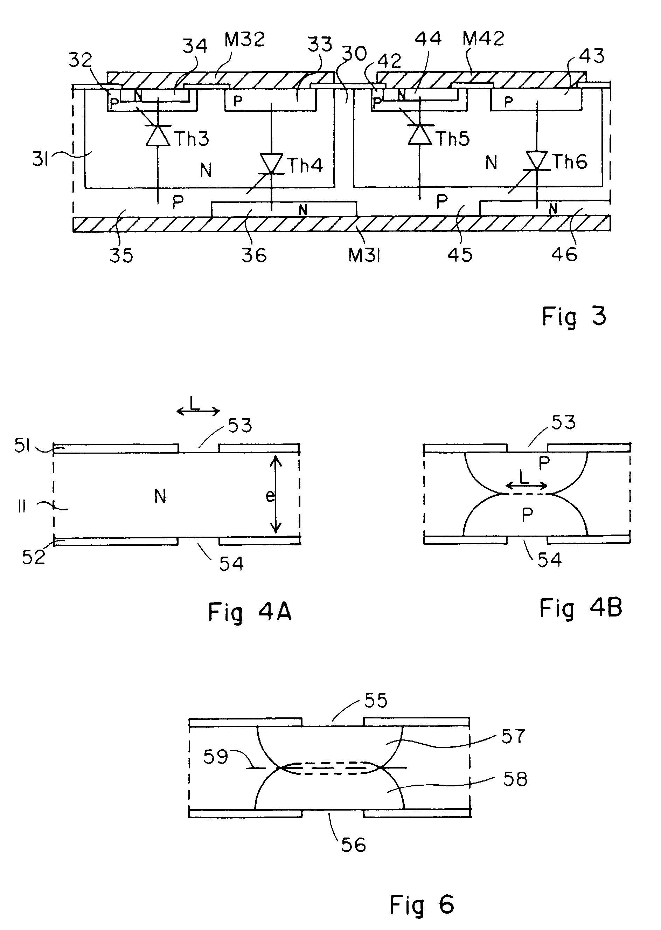

La figure 3 représente schématiquement une structure associant côte à côte deux triacs séparés par un mur d'isolement 30 et formés dans un substrat 31 de type N. Le triac de gauche comprend des thyristors tête-bêche Th3 et Th4. Le triac de droite comprend des thyristors tête-bêche Th5 et Th6. Du côté gauche, sont formées du côté de la face supérieure des régions de type P 32 et 33 (représentées comme séparées par souci d'illustration mais souvent d'une seule pièce). Dans la région 32 est formée une région 34 de type N. Du côté de la face arrière, est formée une région 35 de type P et, dans cette région 35, en regard de la région 33, une région 36 de type N. Du côté droit de la figure, des régions 42 à 46 correspondent respectivement aux régions 32 à 36. On notera que les régions 35 et 45 forment en fait une seule et même couche de type P. La face arrière est revêtue d'une métallisation M31. La région de cathode du thyristor Th3 et la région d'anode du thyristor Th4 sont revêtues d'une métallisation M32. La région de cathode du thyristor Th5 et la région d'anode du thyristor Th6 sont revêtues d'une métallisation M42.

Dans cette structure, en l'absence du mur d'isolement 30, il n'existe pas comme dans le cas des figures précédentes de diodes parasites mais de très nombreux transistors parasites susceptibles d'entrer en conduction et de provoquer la conduction de l'un ou l'autre des triacs en l'absence de signal de gâchette.

Ainsi, dans le cas des trois exemples précédents, le mur d'isolement joue un rôle statique de protection en tension de composants adjacents. Jusqu'à présent, ce rôle a été considérés comme satisfaisant.

La demanderesse a constaté dans le cas de l'assemblage de triacs de la figure 3 que, bien que le fonctionnement du dispositif décrit soit satisfaisant dans toutes les configurations de tension des diverses bornes et lors des fonctionnements habituels, il survenait parfois des incidents quand le courant dans l'un des triacs dépassait un certain seuil. Des problèmes similaires ont été constatés dans les assemblages des figures 1 et 2 et dans plusieurs assemblages monolithiques dont certains de ceux décrits dans EP-A-0721212. Plus particulièrement, dans le cas de la figure 1, si un courant important traverse la diode D1, un courant de fuite peut apparaître dans la structure adjacente et ce courant, s'il est suffisamment élevé, est susceptible de déclencher le thyristor Th1 ; dans le cas de la figure 2, si un courant important traverse la diode D2, le thyristor Th2 est susceptible de se déclencher ; et dans le cas de la figure 3, si un courant important parcourt le thyristor Th3, le thyristor Th5 est susceptible de se déclencher.

Les inventeurs ont d'abord recherché des solutions habituelles pour résoudre ce problème. Ainsi, ils ont tenté d'interrompre la continuité de couches communes à des composants voisins mais, selon le cas, cela s'est avéré impossible ou inefficace. Une autre solution envisagée a été d'interrompre la continuité de la métallisation inférieure. Mais cette solution doit être écartée car c'est la base de la technologie des circuits intégrés de puissance que d'avoir une électrode unique en face arrière.

Les inventeurs se sont alors interrogés sur l'efficacité réelle des murs d'isolement.

Les figures 4A et 4B illustrent le procédé classique de fabrication d'un mur d'isolement. Dans une première étape, illustrée en figure 3A, on délimite dans des masques 51 et 52 formés sur les surfaces supérieure et inférieure d'un substrat 11 des ouvertures 53 et 54 de largeur L. Ensuite, ou bien, on procède à une étape d'implantation pour injecter un dopant de type P dans les ouvertures 53, 54 puis à un recuit, ou bien, on procède à un recuit en présence d'une atmosphère dopante. Dans les deux cas, si la plaquette de silicium à une épaisseur de l'ordre de 200 à 300 µm, il faut procéder à un recuit très long, par exemple de plusieurs centaines d'heures, pour que les dopants s'étendant par diffusion à partir des surfaces inférieure et supérieure se rejoignent comme cela est illustré en figure 4B. Bien entendu, le niveau de dopage en surface est très supérieur au niveau de dopage à l'endroit où les diffusions supérieure et inférieure se rejoignent, c'est-à-dire dans la partie médiane du mur d'isolement. Pour ne pas augmenter indûment la durée de l'étape de diffusion, on s'arrête généralement dès que les deux diffusions se rejoignent et ce d'autant plus que rien n'incitait à prolonger cette étape. Alors, la concentration de dopant au niveau la partie médiane est généralement relativement faible, par exemple de l'ordre de 10¹⁵ à 10¹⁶ atomes/cm³. La largeur du mur d'isolement dans cette partie médiane est alors sensiblement égale à la largeur L des ouvertures 53 et 54. De plus, dans l'art antérieur, on souhaite habituellement réduire autant que possible la dimension des murs d'isolement. Ainsi, la largeur L est généralement choisie aussi petite que possible.

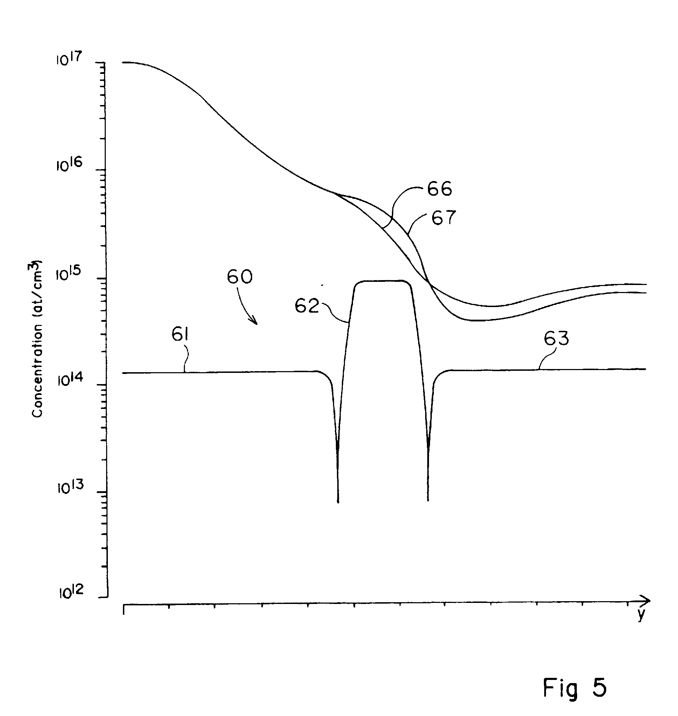

Les inventeurs ont eu l'idée de simuler la densité d'électrons dans un caisson contenant un composant de puissance à l'état passant séparé, par un mur d'isolement du type de celui décrit en relation avec les figures 4A et 4B, d'un caisson contenant un composant que l'on souhaite maintenir bloqué. Le résultat d'une telle simulation est illustré en figure 5. Dans cette figure, l'axe y est dans un plan horizontal correspondant à un plan médian de la structure, c'est-à-dire coupant le mur d'isolement dans sa région médiane, à l'emplacement où les deux diffusions en provenance des faces opposées se rejoignent. La courbe 60 représente l'allure du profil de diffusion dans ce plan. Les portions 61 et 63 correspondent au dopage du substrat de type N (d'un niveau de l'ordre de 10¹⁴ atomes/cm³). La portion 62 correspond à la région médiane du mur d'isolement dont, comme on l'a indiqué, le niveau de dopage maximum peut être de l'ordre de 10¹⁵ atomes/cm³.

Si on simule le passage d'un courant, par exemple d'une densité 2 A/mm², dans un composant vertical situé dans le caisson de gauche, on obtient pour la densité d'électrons et de trous dans le plan médian de la structure des courbes correspondant à celle désignées par les références 66 et 67. A gauche, sous la partie active du composant, la densité de porteurs est de l'ordre de 10¹⁷ atomes/cm³. Les porteurs diffusent dans le substrat et leur densité au niveau du mur d'isolement est supérieure à la concentration de dopants de ce mur. Ceci montre que, dès que la densité de courant dans un caisson dépasse un certain seuil, son mur d'isolement est submergé par les porteurs créés et des porteurs vont diffuser dans le caisson adjacent où ils peuvent créer des perturbations. De façon générale, si la densité de porteurs dans un caisson devient excessive par suite de la conduction de composants contenus dans ce caisson, ces porteurs vont se répandre dans le caisson voisin en traversant le mur d'isolement dans sa région la moins épaisse et la moins dopée. En d'autres termes, un mur d'isolement efficace en statique peut ne plus l'être en dynamique.

Si par exemple, on considère la structure de la figure 3, la métallisation M42 étant connectée comme la métallisation 32, et si un courant élevé passe dans le thyristor Th3, on obtient pour la densité d'électrons et de trous des courbes correspondant à celles désignées par les références 66 et 67. L'arrivée d'électrons dans le caisson contenant les thyristors Th5 et Th6, provoque la mise en conduction de la jonction entre la région P 45 et le substrat 31 et par voie de conséquence du thyristor Th5.

Ainsi, la présente invention propose non seulement de créer des murs d'isolement mais aussi de former ces murs d'isolement de façon que leur partie médiane la moins dopée ait un niveau de dopage suffisant pour constituer une barrière étanche à la diffusion d'électrons d'un caisson à un caisson voisin.

Il est clair que la concentration optimale de la zone médiane du mur d'isolement dépend des concentrations de porteurs susceptibles de survenir au voisinage de cette zone. Toutefois, en pratique, il s'avère que, quand la concentration en atomes dopants au niveau de la partie médiane du mur d'isolement est supérieure à 10¹⁶ atomes/cm³, on évite tout problème dans la majorité des cas.

Selon une variante de la présente invention, on pourra également jouer sur la largeur de la zone médiane du mur d'isolement.

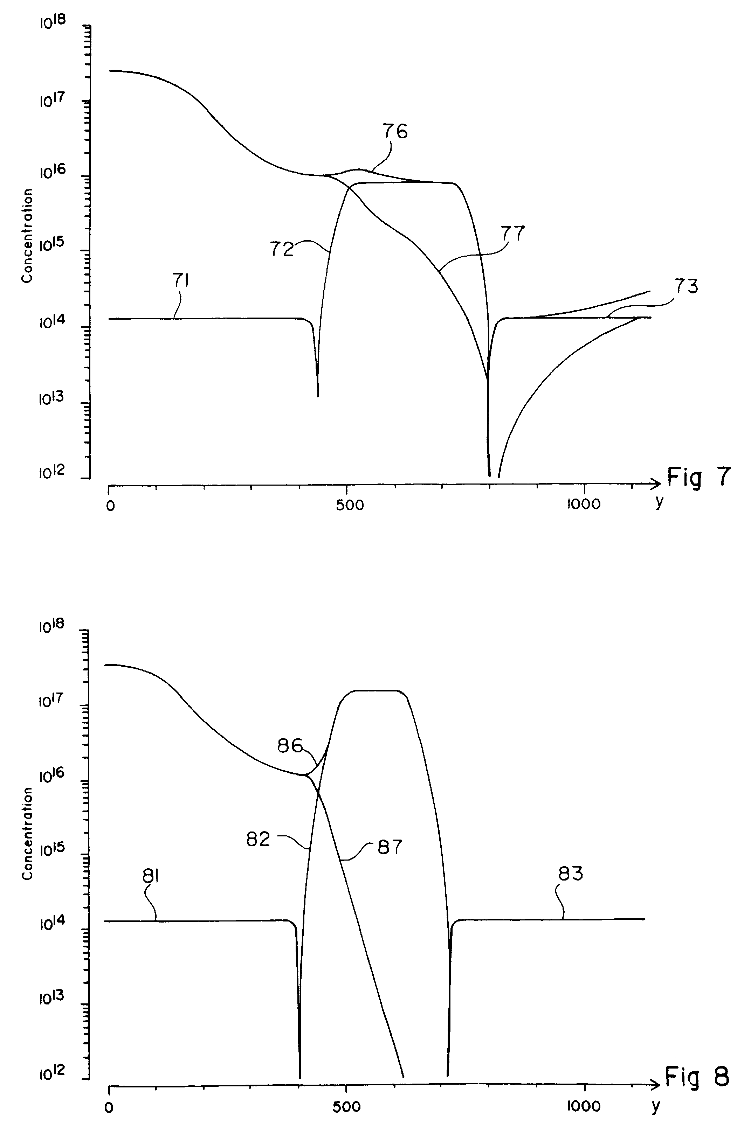

La figure 6 illustre un mur d'isolement formé selon la présente invention. Ce mur est réalisé en poursuivant la diffusion de zones dopées à partir d'ouvertures 55 et 56 pour que les régions diffusées 57 et 58 s'interpénètrent et que le niveau de dopage au niveau de la ligne médiane 59 soit accru.

La mise en oeuvre de la présente invention implique pour une plaquette d'épaisseur donnée, d'augmenter la durée du recuit de diffusion lors de la formation des murs d'isolement et/ou d'augmenter la largeur des murs d'isolement. De préférence, la largeur de l'ouverture à partir de laquelle est formée le mur d'isolement sera supérieure à 1,3 fois la demi-épaisseur du substrat.

Les figures 7 et 8 illustrent l'effet de murs d'isolement formés selon la présente invention dans le même cas que celui de la figure 5.

En figure 7, la concentration du mur d'isolement dans sa partie médiane est désignée par la référence 72. Elle culmine environ à 10¹⁶ atomes/cm³. Dans cette figure, la partie médiane a une largeur d'environ 300 µm et les densités d'électrons et de trous sont respectivement désignées par les références 77 et 76.

En figure 8, la concentration du mur d'isolement dans sa partie médiane est désignée par la référence 82. Elle culmine environ à 10¹⁷ atomes/cm³. La partie médiane a une largeur d'environ 100 µm. Les densités d'électrons et de trous sont respectivement désignées par les références 86 et 87.

On voit que dans les deux cas, le mur d'isolement est suffisamment important pour éviter la transmission d'électrons au niveau des caissons 71 et 81 dans lesquels sont créés des porteurs libres sous l'effet du passage d'un courant important aux caissons adjacents 73 et 83.

Bien entendu, il est également souhaitable pour mettre en oeuvre la présente invention de réduire l'épaisseur des plaquettes semiconductrices à partir desquelles sont formés les composants de façon à réduire les durées de diffusion.

La présente invention est susceptible de diverses variantes et modifications qui apparaîtront à l'homme de l'art, notamment en ce qui concerne la nature des composants formés dans les caissons séparés par des murs d'isolement et le nombre de ces caissons.

## Revendications

1. Mur d'isolement destiné à séparer des composants élémentaires formés dans des caissons différents, un composant situé dans l'un au moins des caissons étant susceptible de fonctionner avec une densité de courant importante, caractérisé en ce que le mur d'isolement présente dans sa partie médiane une concentration de porteurs supérieure à 10¹⁶ atomes/cm³.

2. Mur d'isolement selon la revendication 1, caractérisé en ce que la largeur des ouvertures à partir desquelles sont formées les diffusions de dopants dans les surfaces supérieure et inférieure du substrat est supérieure à 1,3 fois la demi-épaisseur du substrat.

3. Mur d'isolement selon la revendication 1 ou 2, appliqué à constituer une séparation entre deux caissons contenant des triacs verticaux.

4. Mur d'isolement selon la revendication 1 ou 2, appliqué à séparer deux caissons dont l'un au moins comprend une diode, un thyristor ou un triac vertical.

5. Mur d'isolement selon l'une quelconque des revendications 1 à 4, dans lequel les divers composants sont de type vertical et la puce semiconductrice comprend une métallisation unique en face arrière.
